# EUROPÄISCHE PATENTSCHRIFT

(11) **EP 2 834 389 B1**
(45) Veröffentlichungstag und Bekanntmachung des Hinweises auf die Patenterteilung: **30.11.2016**
(21) Anmeldenummer: 13709319.1
(22) Anmeldetag: 05.03.2013
(51) Int. Cl.: C23C 14/34

(54) **BESCHICHTUNGSQUELLE MIT EINEM AN EINE INDIREKTE KÜHLVORRICHTUNG ANGEPASSTEN TARGET**
COATING SOURCE WITH A TARGET ADAPTED TO AN INDIRECT COOLING DEVICE
SOURCE DE REVÊTEMENT AVEC CIBLE ADAPTÉE À UN DISPOSITIF DE REFROIDISSEMENT INDIRECT

(30) Priorität: 04.04.2012 DE 102012006717
(43) Veröffentlichungstag der Anmeldung: 11.02.2015
(73) Patentinhaber: Oerlikon Surface Solutions AG, Pfäffikon, 8808 Pfäffikon (CH)
(72) Erfinder: KRASSNITZER, Siegfried, 6800 Feldkirch (AT); HAGMANN, Juerg, 9468 Sax (CH)
(74) Vertreter: Kempkens, Anke
(86) Internationale Anmeldenummer: PCT/EP2013/000623
(87) Internationale Veröffentlichungsnummer: WO 2013/149692

(56) Entgegenhaltungen:
- EP-A1- 0 512 456
- DE-A1- 19 535 894
- Anonymous: "Hochwärmeleitende Karbonfolien Serie KU-CB1200", Kunze Folien GmbH Produktdatenblatt , 30. November 2010 (2010-11-30), XP002697228, Gefunden im Internet: URL:http://www.heatmanagement.com/local/me dia/hmproducts/ku-cb1200-50/ku-cb1200_date nblatt.pdf [gefunden am 2013-05-16]

## Beschreibung

Die vorliegende Erfindung betrifft eine Beschichtungsquelle welche ein Target umfasst, dessen Oberfläche als Materialquelle im Rahmen von PVD Verfahren, insbesondere unter Vakuumbedingungen dient. Die Erfindung betrifft insbesondere Beschichtungsquellen mit solchen Targets welche für das Sputtering (im Folgenden wird der Begriff "Sputtering" gleichbedeutend mit dem PVD Verfahren "Zerstäuben" verwendet). Ein solches Target wird in der Anwendung meist von einer Quellenhalterung gehaltert, in der Mittel zur Kühlung des vorgesehen sind.

Beim Sputtering wird unter Vakuumbedingungen die Oberfläche eines Targets mit Ionen bombardiert. Durch das Bombardement wird Material aus der Targetoberfläche herausgeschlagen, welches sich auf dafür vorgesehene, im Sichtfeld der Targetoberfläche platzierte Substrate ablegen kann. Die dafür benötigten Ionen werden durch ein über der Targetoberfläche aufgebautes Plasma bereitgestellt. Durch Anlegen einer negativen Spannung an das Target werden die Ionen zu diesem hin beschleunigt. Je mehr Ionen pro Zeiteinheit fliessen, umso höher wird die Beschichtungsrate. Je höher die an das Target angelegte Spannung ist, umso höher ist die Auftreffgeschwindigkeit der Ionen auf der Targetoberfläche und umso höherenergetisch ist das aus dem Target herausgeschlagene zerstäubte Material. Ein hoher Leistungseintrag ist daher wünschenswert. Ausserdem sind Abhängigkeiten zwischen Ionisationsgrad des zerstäubten Materials und der Leistungsdichte bekannt. Diese Effekte werden im HIPIMS Verfahren genutzt. Die mittlere Leistungsdichte, die an ein solches Sputtertarget angelegt wird, liegt in der Regel im Bereich von 5 W/cm² bis 30 W/cm2.

Sputtering ist allerdings eine PVD Beschichtungsmethode mit geringer Energie-Effizenz. Dies bedeutet, dass ein grosser Teil der bereitgestellten Energie im Target in Wärme umgesetzt wird und das Target sich erhitzt. Diese Wärme muss über eine Kühlung abgeführt werden. Hierfür gibt es gemäss Stand der Technik unterschiedliche Ansätze die im Folgenden kurz skizziert werden sollen.

### a) direkt gekühltes Target

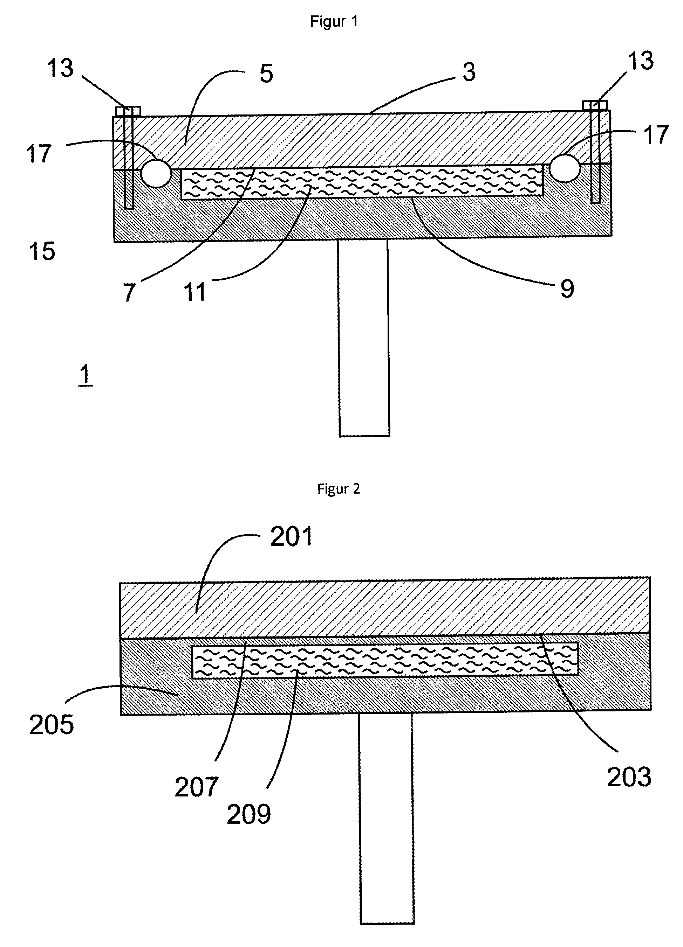

Bei einem direkt gekühlten Target 1 wie in Figur 1 schematisch dargestellt wird die an der Targetoberfläche 3 in Wärme umgesetzte Leistung durch Wärmeleitung im Targetmaterial 5 zur Targetrückseite 7 geleitet. Die in einem Wasserkanal 9 fliessende Kühlflüssigkeit 11 kann den Wärmefluss entsprechend deren Wärmekapazität und den Strömumgsverhältnissen abführen. Es besteht ein sehr guter direkter Wärmekontakt zwischen Targetrückseite 7 und der Kühlflüssigkeit 11. In diesem Fall ist es allerdings notwendig, das Target z.B. über Schrauben 13 an den Grundkörper 15 anzubinden. Ausserdem muss eine Dichtung 17 vorgesehen werden, welche das Vakuum gegenüber der Kühlflüssigkeit 11, beispielsweise Wasser, abdichtet. In Figur 1 sind ausserdem elektrische Zuleitungen 6 skizziert. Ansonsten ist die Zeichnung lediglich eine schematische Zeichnung. Weitere Komponenten beispielsweise zur Vakuumerzeugung, Isolation, Zuführung und Abführung der Kühlflüssigkeit sind dem Experten bekannt und auf ihre Darstellung wurde hier verzichtet.

Dieses direkt gekühlte Target besticht zwar durch eine sehr gute Kühlleistung, hat aber wegen der Kühlmittel-Vakuum Dichtung und dem notwendigen Lösen des Wasser-Target Verbundes bei Targetwechsel entscheidende Nachteile. So besteht zum Beispiel die Gefahr, Kühlflüssigkeitslecks zu generieren. Diese Gefahr ist dann besonders gross, wenn ein häufiger Wechsel des Targetmaterials benötigt wird.

### b) indirekt gekühltes Target

In diesem Zusammenhang erwähnt Kerschbaumer im Dokument EP0512456A1, dass Targetplatten bekanntlich auf einer Kühlplattenanordnung für die Abfuhr der Wärme montiert werden. Kerschbaumer erwähnt aber auch, dass obwohl sich die grösste Wärmeabfuhr dadurch erreichen liesse, dass die Targetplattenrückseite direkt mit einem Kühlmedium, flüssig oder gasförmig, in Kontakt gebracht wird, diese Kühlart aus vakuumtechnischen Gründen meist nicht erwünscht ist. Deshalb ist es bekannt, ein Leitungssystem für das Kühlmedium von der Auflagefläche an der Targetplatte durch eine dünne, membranartige bzw. folienartige, wärmeleitende Wandung zu trennen, womit einerseits die vakuumtechnischen Dichtungsprobleme, gegenüber einer direkten Kühlung, entfallen, anderseits, durch den Druuck des Kühlmediums auf die membranartige Zwischenwand und auf die Targetplattenrückseite, ein sehr guter Wärmedurchgang von Targetplatte auf Kühlmedium gewährleistet werden kann. Dabei werden die Druckkräfte des Mediums von der Targetplatte aufgenommen. Im gleichem Dokument offenbart Kerschbaumer ein Verfahren zur Montage bzw. Demontage einer Targetplatte in einem Vakuumprozessraum, wobei eine Targetplatte mittels eines zentralen und/oder peripheren Bajonettverschlusses montiert bzw. demontiert wird, und wobei die Wandung der Prozesskammer eine Kühlplatte mit Kühlkanälen, welche gegenüber der eingesetzten Targetplatte mittels folienartiger Membranen verschlossen sind, dergestalt, dass durch Druckbeaufschlagung des Kühlmediums der Bajonettverschluss über die erwähnten Membranen gespannt wird. Kerschbaumer erwähnt ausserdem, dass die Kanäle in der Kühlplatte gegen den Prozessraum hin mit gut wärmedurchleitenden Membranen, vorzugsweise Metallfolien, dichtend verschlossen sind.

Auch in diesem Zusammenhang offenbart Wollenberg im Dokument DE19535894A1 ein Target für die Sputterkathode einer Vakuumbeschichtungsanlage mit einem das zu zerstäubende Material zumindest teilweise umschliessenden Rahmen zur Halterung des plattenförmigen Targets auf der Kathodengrund- oder Rückenplatte und mit einer zwischen Rahmen und Kathodenrückenplatte angeordneten Trennfolie oder Zwischenlage aus nachgiebigem, aber gut wärmeleitendem Werkstoff und ein Verfahren zu seiner Herstellung.

Bei einem indirekt gekühltem Target, wie in Figur 2 dargestellt, wird das Target 201 mit seiner Rückseite 203 an einer Quellenhalterung 205 befestigt (z.B. geschraubt oder geklemmt) wobei in die Quellenhalterung 205 eine in sich geschlossene Kühlplatte 207 integriert ist. Die Kühlplatte 207 umfasst beispielsweise einen mit Kühlmittel durchflossenen Kühlkanal 209 über dessen bewegte Flüssigkeit die Wärme abgeführt wird.

In diesem Fall wird der Kühlflüssigkeitskanal durch eine massive fixe Abdeckung begrenzt. Das Target wird zum Zweck der Kühlung und der elektrischen Kontaktierung an diese Abdeckung zum Beispiel mit Schrauben am Umfang oder gegebenenfalls in der Mitte des Targets befestigt. Diese Methode führt unter anderem zu zwei Problemen:

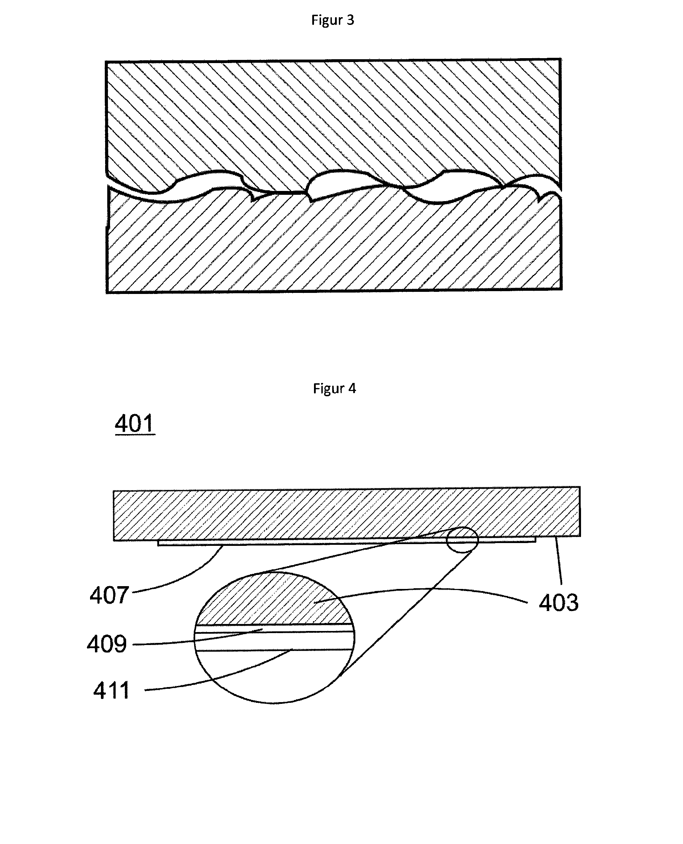

Der Wärmeübergang wird durch die Oberfläche der Targetrückseite und die Oberfläche der Kühlplatte gebildet. Ohne besondere Massnahmen bilden diese beiden Oberflächen eine Grenzfläche, die stark von einer idealen glatten Kontaktpaarung abweicht. Eine solche Situation ist in Figur 3 dargestellt. Der Wärmeübergang ist in diesem Fall stark reduziert und erweist sich als druckabhängig. Anpressdruck kann aber beispielsweise nur über die Befestigungsschrauben eingeleitet werden, d.h. der Wärmeübergang kann nur lokal verbessert werden.

Diese Situation kann durch Vorsehen einer Kontaktfolie zwischen den beiden Oberflächen verbessert werden. Diese kann z.B. aus Indium, Zinn, oder Graphit bestehen. Diese Folien können durch ihre Duktilität Unebenheiten zwischen der Targetrückseite und der Oberfläche der Kühlplatte ausgleichen. Ausserdem kann der Anpressdruck gleichmässiger über die Fläche aufgebracht werden.

Ein Nachteil dieser Methode ist, dass die Montage einer Kontaktfolie, insbesondere bei senkrecht montierten Targets, schwierig und umständlich ist. Dies ist besonders dann relevant, wenn es zu häufigen Wechsel des Targetmaterials kommt. Im Falle von Graphitfolien ist die laterale Wärmeleitfähigkeit zwar gut, die transversale Wärmeleitfähigkeit ist jedoch schlecht. Graphitfolien müssen daher einerseits dünn sein, damit deren schlechte transversale Wärmeleitfähigkeit den Kühlprozess nicht verhindern. Andererseits ist eine gewisse Foliendicke notwendig, um eine Beschädigung der Folie bei der Montage zu vermeiden. Es werden daher Graphitfolien mit einer Dicke nicht unter 0.5mm verwendet.

Es besteht daher ein Bedürfnis nach einer Beschichtungsquelle mit einer verbesserten Kühlvorrichtung für Targets, die insbesondere das Wechseln des Targetmaterials gegenüber den aus dem Stand der Technik bekannten Vorrichtungen verbessert.

Die Erfindung ist in den Patentansprüchen angegeben.

Die Erfindung beruht auf einer Weiterentwicklung der oben skizzierten indirekten Kühlvorrichtung. Erfindungsgemäss wird die Aufgabe dadurch gelöst, dass an der Rückseite des Targetkörpers eine selbstklebende Karbonfolie in fixem Verbund mit dem Targetkörper angebracht wird. Die Folie kann bei nicht montiertem Targetkörper mit der Rückseite des Targetkörpers gleichmässig und ohne Zwischenräume verklebt werden. Ein sehr guter Wärmekontakt zwischen der Rückseite des Targetkörpers und der Karbonfolie ist somit gewährleistet. Der Targetkörper kann dann in einfacher Art und Weise an der Quellenhalterung montiert werden. Die am Target fixierte Karbonfolie hat nun zwischen der Oberfläche der Kühlplatte und der Rückseite des Targetkörpers die Wirkung einer Kontaktfolie.

Solche Karbonfolien sind beispielweise aus dem Produktdatenblatt der Firma Kunze Folien GmbH bekannt.

Der Einsatz einer solchen selbstklebenden Karbonfolie ist jedoch im Bereich der Vakuumtechnologie nicht üblich. Da die für die Herstellung der selbstklebenden Karbonfolie verwendeten Kleber unter Vakuumbedingungen stark ausgasen und damit einen negativen Einfluss auf das Vakuum haben und die entsprechenden flüchtigen Bestandteile zur Kontamination der unter Vakuum zu behandelnden Substrate führt, kommen solche Substanzen nicht zum Einsatz.

Demgegenüber haben die Erfinder zu ihrem Erstaunen festgestellt, dass die selbstklebenden Folien, wie oben beschrieben eingesetzt, nicht merkbar die skizzierten nachteiligen Effekte haben. Eine diesbezügliche Erklärung könnte darin liegen, dass aufgrund des engen Kontaktes zur Rückseite der Targetoberfläche und aufgrund des Kontaktes der Karbonfolie zur Membran ein Ausgasen des Klebstoffs extrem verlangsamt und somit nicht relevant ist.

Die Erfindung wird nun im Detail mit Hilfe der Figuren und anhand verschiedener Ausführungsbeispiele erläutert.
Figur 1 zeigt eine herkömmliche Beschichtungsquelle mit direkter Kühlung.
Figur 2 zeigt eine herkömmliche Beschichtungsquelle mit indirekter Kühlung.
Figur 3 zeigt den begrenzten Wärmekontakt bei einer Beschichtungsquelle mit Kühlung gemäss Figur 2.
Figur 4 zeigt im Querschnitt ein-Target mit erfindungsgemäss angebrachter selbstklebender Karbonfolie.
Figur 5 zeigt ein in eine Beschichtungsquelle mit indirekter Kühlung integriertes Target.
Figur 6 zeigt die erfinderische Beschichtungsquelle mit dem integrierten Target in einer Ausführungsform.

Dementsprechend zeigt Figur 4a ein Target 401, an dessen Targetrückseite 403 eine einseitig selbstklebende Karbon Folie 407 mit einer Dicke von zwischen 0.1 mm und weniger als 0.5 mm angebracht ist. Die bevorzugte und im Beispiel gewählte Dicke der Karbonfolie beträgt 0.125 mm. Im Beispiel wurde eine Kontaktfolie der Firma Kunze mit der Produktidentifikationnummer KU-CB1205-AV eingesetzt.

In Figur 4 ebenfalls gezeigt ist ein genauerer Ausschnitt der Grenzfläche Targetrückseite und selbstklebende Karbonfolie. Die Karbonfolie umfasst dabei einen Klebefilm 409 welcher die Karbonfolie zur selbstklebenden Folie macht, sowie einen Karbonfilm 411.

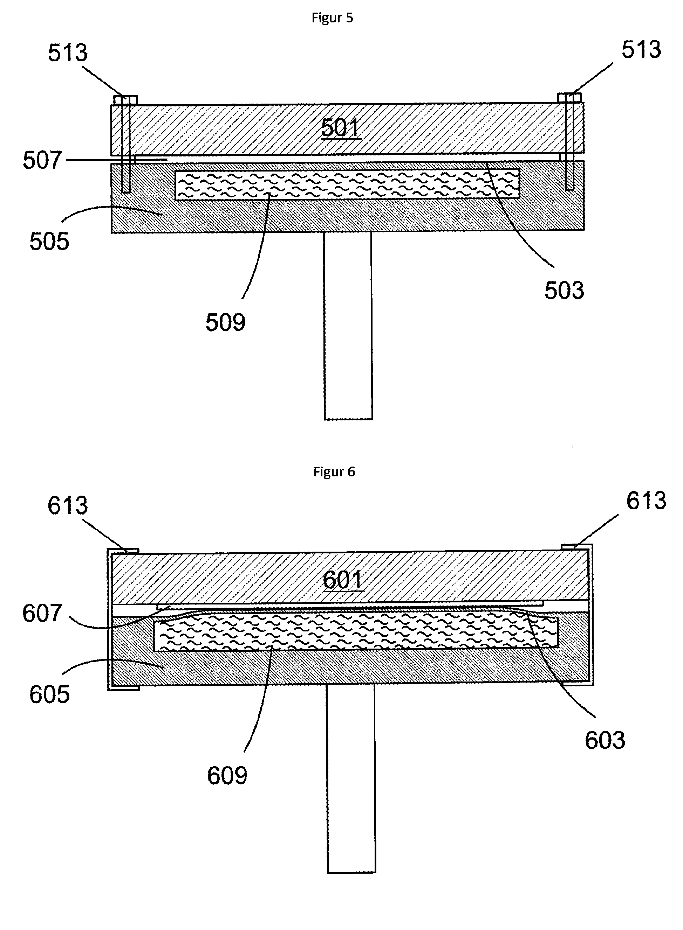

Das Target gemäss Figur 4 lässt sich gut in eine Beschichtungsquelle mit indirekter Kühlung integrieren, wie in Figur 5 gezeigt: Das Target 501 mit selbstklebender Karbonfolie 507 wird mit den Schrauben 513 an die Vorderseite einer Quellenhalterung 505 fixiert, wobei in die Quellenhalterung ein Kühlplatte mit Kühlkanal 509 integriert ist und die Karbonfolie 507 auf die Rückseite 503 der Kühlplatte gepresst wird, wodurch ein guter Wärmekontakt zur Kühlplatten entsteht. Aufgrund der erfindungsgemässen Tatsache, dass die Karbonfolie auf die Targetrückseite aufgeklebt ist wird ein Targetwechsel sehr einfach, selbst wenn das Target in einer Beschichtungskammer vertikal montiert ist.

Eine Beschichtungsquelle gemäss der vorliegenden Erfindung umfasst eine indirekte Kühlung mittels beweglicher Membrane, wie in Figur 6 gezeigt. Der Aufbau ist ähnlich dem in der Figur 5 skizzierten mit Target 601 mit selbstklebender Karbonfolie 607, Quellenhalterung 605, Kühlkanal 609, wobei allerdings diejenige Wand der Kühlplatte, welche den Kühlkanal 609 von der Karbonfolie 607 trennt, in dieser bevorzugten Ausführungsform als flexible Membrane 603 ausgebildet ist. Das Kühlmittel kann beispielsweise Wasser sein. Beim Targetwechsel ist kein Lösen einer Wasserdichtung notwendig. Wird das Target 601 auf der Quellenhalterung 605 durch geeignete Massnahmen fixiert (z.B. mittels Klammern 613 oder Schrauben) so wird aufgrund des im Kühlkanal 609 herrschenden hydrostatischen Drucks die Membrane 603 gleichförmig an die Targetrückseite und damit an die selbstklebende Karbonfolie 607 angedrückt und es kommt zu einem sehr guten, flächigen Wärmekontakt.

Dass dabei die selbstklebende Karbonfolie eine wesentliche Rolle spielt dokumentiert die folgende Tabelle 1 in eindrucksvoller Weise, bei der die Targettemperatur mit und ohne selbstklebende Karbonfolie für unterschiedliche Sputterleistungen und zwei verschiedene Materialzusammensetzungen verglichen wird:

**Tabelle 1**

| Nr | Target Typ | Karbonfolie | Sputterleistung | Targettemperatur |
|---|---|---|---|---|
| 1 | AlCr(70:30 at%) | Nein | 5KW | 235°C |
| 2 | AlCr(70:30 at%) | Ja | 5KW | 132°C |
| 3 | AlCr(70:30 at%) | Ja | 7.5KW | 171C |
| 4 | AlCr(70:30 at%) | ja | 10KW | 193°C |
| 5 | AlTi(67:33 at%) | ja | 5KW | 138°C |
| 6 | AlTi(67:33 at%) | ja | 7.5KW | 182°C |

Ein Target ohne erfinderischer selbstklebender Karbonfolie wie in Messung Nr. 1 der Tabelle 1 kann aus mechanischen Gründen nur bis zu einer Sputterleistung von 2.5 kW sicher betrieben werden. Durch Verwendung eines erfindungsgemässen Targets mit selbstklebender Karbonfolie wird die Leistungsverträglichkeit mehr als verdoppelt.

Bei anderen Targetmaterialien, d.h. bei anderen AlTi bzw. AlCr Verhältnissen und auch bei reinen Aluminium, Titan und/oder Chromtargets zeigt sich qualitativ ein ähnliches Bild. Die vorliegende Erfindung zeigt eine besonders gute Wirkung wenn Targetdicken zwischen 6 mm und 18 mm verwendet werden. Bevorzugt liegt die Targetdicke zwischen 6 mm und 12 mm.

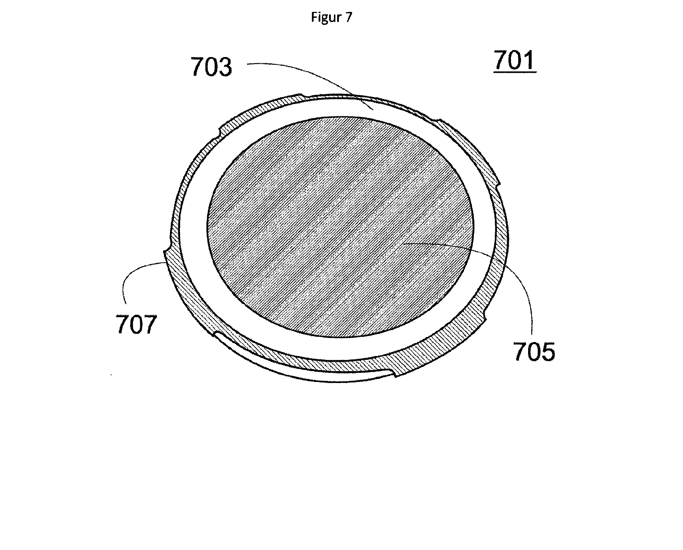

Gemäss einer besonders bevorzugten Ausführungsform der vorliegenden Erfindung ist das Target 701 als Target mit selbstklebender Karbonfolie 705 auf der Targetrückseite 703 und Bajonett Profilierung 707 entsprechend Figur 7 ausgeführt. Eine bevorzugte Beschichtungsquelle gemäss dieser Ausführungsform weisst die wie in Rahmen der Figur 6 beschriebene indirekte Kühlung mit Membrane und die für die Bajonett-Fixierung notwendigen Gegenstücke auf. Dadurch wird ein hoher und homogener Anpressdruck ermöglicht. Diese bevorzugte Ausführungsform ist speziell im Zusammenhang mit pulvermetallurgischen Targets von besonderem Vorteil, weil diese ab einer Temperatur von 150°C mechanisch geschwächt werden und die thermische Ausdehnung steigt. Aufgrund der Reduktion der Targettemperatur und den durch die Bajonett-Fixierung gegebenen mechanischen Spielraum reduziert sich dieser thermische Stress erheblich. Für ChromTargets werden zum Beispiel Leistungsdichten bis 100W/cm² möglich.

Es wurde ein Target offenbart, welches als Materialquelle für ein Abscheideverfahren aus der Gasphase ausgebildet ist mit einer Vorderseite und einer Rückseite, das dadurch gekennzeichnet ist, dass an der Rückseite eine selbstklebende Karbonfolie aufgeklebt ist.

Das Target kann als Materialquelle für ein Sputtering-Verfahren und/oder für ein Funkenverdampfungs-verfahren ausgebildet sein. Die Dicke der selbstklebenden Karbonfolie kann beispielsweise zwischen 0.125mm und 0.5mm betragen und bevorzugt eine Dicke von 0.125mm aufweisen.

Es wurde eine Beschichtungsquelle umfassend ein wie oben beschriebenes Target offenbart, welches an einer Quellenhalterung angeordnet ist, in die eine indirekte Kühlung mit Kühlkanal integriert ist.
Bei der Beschichtungsquelle ist diejenige Wand, welche den Kühlkanal von der selbstklebenden Karbonfolie trennt, als flexible Membrane ausgebildet wodurch die selbstklebende Karbonfolie einen flächigen Kontakt mit der Membrane bildet.

Der Umfang des Targets der Beschichtungsquelle ist vorzugsweise so ausgebildet, dass er mit der Quellenhalterung in Form eines Bajonettverschlusses zusammenwirkt, wodurch ein hoher und homogener Anpressdruck verwirklicht ist.

Bei einer indirekt gekühlten Beschichtungsquelle wäre es auch möglich, die selbstklebende Karbonfolie an diejenige Wand zu kleben, welche den Kühlkanal von der Rückseite eines Targets trennt. Die gilt auch dann, wenn diese Wand als Membrane ausgebildet ist. Dies hätte allerdings den Nachteil, dass bei Beschädigung der Folie, diese von der Quellenhalterung umständlich entfernt und erneuert werden müsste. Ist die selbstklebende Karbonfolie dünn genug, so ist es auch möglich diese sowohl an der Targetrückseite als auch and derjenigen Wand anzubringen, welche den Kühlkanal von der Rückseite des Targets trennt.

## Patentansprüche

1. Beschichtungsquelle umfassend ein Target (601, 701) mit Vorder- und Rückseite, dessen Rückseite an einer Wand der Quellenhalterung (605) angeordnet ist, in die eine indirekte Kühlung mit Kühlkanal (609) integriert ist, wobei das Target (601, 701) auf der Quellenhalterung (605) durch geeignete Massnahmen fixiert ist und die Wand der Quellenhalterung (605), an der das Target (601, 701) angeordnet ist, als flexible Membrane (603) ausgebildet ist, welche den Kühlkanal (609) von der Rückseite des Targets (601, 701) trennt, **dadurch gekennzeichnet, dass** an der Rückseite des Targets und/oder an derjenigen Wand der Quellenhalterung, an der das Target angeordnet ist, eine selbstklebende Karbonfolie (607, 705) aufgeklebt ist.

2. Beschichtungsquelle nach Anspruch 1, **dadurch gekennzeichnet, dass** die selbstklebende Karbonfolie (607, 705) derart aufgeklebt ist, dass wenn die Membrane (603) während eines Sputtering-Verfahrens aufgrund des im Kühlkanal (609) herrschenden hydrostatischen Drucks gleichförmig an die Rückseite des Targets (601, 701) angedrückt wird, sie auch an die selbstklebende Karbonfolie (607, 705) angedrückt wird, dergestalt dass es zu einem flächigen Wärmekontakt zwischen der Membrane (603) und der Rückseite des Targets (601, 701) kommt, welcher es erlaubt die Temperatur des Targets (601, 701) so gering zu halten, dass die Leistungsverträglichkeit des Targets (601, 701) im Vergleich mit der Leistungsverträglichkeit des gleichen Targets in derselben Beschichtungsquelle aber ohne selbstklebende Karbonfolie (607, 705) zumindest verdoppelt werden kann.

3. Beschichtungsquelle nach einem der vorangehenden Ansprüche 1 bis 2, **dadurch gekennzeichnet, dass** die Dicke der selbstklebenden Karbonfolie (607, 705) zwischen 0.125 mm und weniger als 0.5 mm beträgt und bevorzugt eine Dicke von 0.125 mm aufweist.

4. Beschichtungsquelle nach einem der vorangehenden Ansprüche 1 bis 3, **dadurch gekennzeichnet, dass** die Dicke des Targets (601, 701) zwischen 6 mm und 18 mm beträgt und bevorzugt eine Dicke von 6 mm bis 12 mm aufweist.

5. Beschichtungsquelle nach einem der vorangehenden Ansprüche 1 bis 4, **dadurch gekennzeichnet, dass** als geeignete Massnahmen zur Fixierung des Targets (601, 701) auf der Quellenhalterung (605) eine Bajonet-Fixierungssystem vorgesehen ist.

6. Beschichtungsquelle nach Anspruch 4, **dadurch gekennzeichnet, dass** der Umfang (707) des Targets (701) mit der Quellenhalterung in Form eines Bajonettverschlusses zusammenwirkt, wodurch ein hoher und homogener Anpressdruck verwirklicht ist.

7. Beschichtungsquelle nach einem der vorangehenden Ansprüche, **dadurch gekennzeichnet, dass** das Target (601, 701) pulvermetallurgisch hergestellt ist.

8. Methode zur Beschichtung von Substraten, wobei zur Abscheidung einer Schicht mittels eines Sputtering-Verfahrens eine Beschichtungsquelle nach einem der vorangehenden Ansprüche 1 bis 7 verwendet wird.

9. Methode nach Anspruch 8, **dadurch gekennzeichnet, dass** die Temperatur eines AlCr(70:30at.%)-Targets maximal 193°C beträgt, oder die Temperatur eines AlTi(67:33 at %)-Targets maximal 182 °C beträgt.

10. Methode nach Anspruch 9, **dadurch gekennzeichnet, dass** eine Sputterleistung am Target von bis 10 KW verwendet wird.

11. Methode nach einem der vorangehenden Ansprüche 8 bis 10, **dadurch gekennzeichnet, dass** eine Chrom-Target-Leistungsdichte von bis 100 W/cm² verwendet wird.

12. Methode nach einem der vorangehenden Ansprüche 8 bis 11, **dadurch gekennzeichnet, dass** das verwendete Target ein AlTi-, AlCr-, Al-, Ti-, oder Cr-Target ist.

## Claims

1. Coating source comprising a target (601, 701) with a front side and a rear side, whose rear side is placed on one wall of the source holder (605) into which an indirect cooling with a cooling channel (609) is integrated, wherein the target (601, 701) is fastened onto the source holder (605) through suitable measures and the wall of the source holder (605) onto which the target (601, 701) is fastened is executed as flexible membrane (603), which separates the cooling channel (609) from the rear side of the target (601, 701), **characterized in that** a self-adhesive carbon film (607, 705) is pasted onto the rear side of the target and/or onto that wall of the source holder onto which the target is fastened.

2. Coating source according to claim 1, **characterized in that** the self-adhesive carbon film (607, 705) is glued in such a manner that when the membrane (603) is pressed uniformly on the rear side of the target (601, 701) during a sputtering process due to the hydrostatic pressure prevailing in the cooling channel (609), it is also pressed onto the self-adhesive carbon film (607, 705) in such a manner that it results in an extensive thermal contact between the membrane (603) and the rear side of the target (601, 701), which enables the temperature of the target (601, 701) to be held so low that the output tolerance of the target (601, 701) as compared with the output tolerance of the same target in the same coating source but without self-adhesive carbon film (607, 705) can be at least doubled.

3. Coating source according to one of the preceding claims 1 to 2, **characterized in that** the thickness of the self-adhesive carbon film (607, 705) is between 0.125mm and less than 0.5mm and preferably has a thickness of 0.125mm.

4. Coating source according to one of the preceding claims 1 to 3, **characterized in that** the thickness of the target (601, 701) is between 6mm and 18mm and preferably has a thickness from 6mm to 12mm.

5. Coating source according to one of the preceding claims 1 to 4, **characterized in that** as suitable measures for fastening the target (601, 701) onto the source holder (605) a bayonet joint system is provided.

6. Coating source according to claim 4, **characterized in that** the perimeter (707) of the target (701) cooperates with the source holder in the form of a bayonet joint, whereby a high and homogenous contact pressure is achieved.

7. Coating source according to one of the preceding claims, **characterized in that** the target (601, 701) is produced by means of a powder-metallurgical process.

8. Method for coating substrates, wherein for the deposition of a layer by means of a sputtering process a coating source according to one of the preceding claims 1 to 7 is used.

9. Method according to claim 8, **characterized in that** the maximum temperature of an AlCr(70:30 at%) target is 193°C or the maximum temperature of an AlTi(67:33 at%) target is 182°C.

10. Method according to claim 9, **characterized in that** a sputtering output at the target of up to 10kW is used.

11. Method according to one of the preceding claims 8 to 10, **characterized in that** a chromium target power density of up to 100W/cm2 is used.

12. Method according to one of the preceding claims 8 to 11, **characterized in that** the used target is an AlTi, AlCr, Al, Ti or Cr target.

## Revendications

1. Source de matière de revêtement comprenant une cible (601, 701) avec une face avant et une face arrière, dont la face arrière est disposée sur une paroi du support de source (605), dans laquelle est intégré un refroidissement indirect avec un canal de refroidissement (609), la cible (601, 701) étant fixée sur le support de source (605) par des mesures appropriées, et la paroi du support de source (605), sur laquelle est disposée la cible (601, 701), étant conçue sous forme d'une membrane (603) souple, laquelle sépare le canal de refroidissement (609) de la face arrière de la cible (601, 701), **caractérisée en ce que**, sur la face arrière de la cible et/ou sur la paroi du support de source, sur laquelle est disposée la cible, est collé un film de carbone (607,705) auto-adhésif.

2. Source de matière de revêtement selon la revendication 1, **caractérisée en ce que** le film de carbone (607, 705) auto-adhésif est collé de telle manière, que, lorsque la membrane (603), pendant un procédé de pulvérisation cathodique, en raison de la pression hydrostatique régnant dans le canal de refroidissement (609), est appliquée de manière uniforme sur la face arrière de la cible (601, 701), elle est également appliquée sur le film de carbone (607, 705) auto-adhésif, de manière telle qu'il se produit un contact thermique de surface entre la membrane (603) et la face arrière de la cible (601, 701), lequel permet de maintenir la température de la cible (601, 701) aussi faible que la compatibilité de puissance de la cible (601, 701) peut être au moins doublée comparativement à la compatibilité de puissance de la même cible dans la même source de matière de revêtement, mais sans film de carbone (607, 705) auto-adhésif.

3. Source de matière de revêtement selon l'une quelconque des revendications précédentes 1 à 2, **caractérisée en ce que** l'épaisseur du film de carbone (607, 705) auto-adhésif s'élève de 0,125 mm à moins de 0,5 mm et présente de préférence une épaisseur de 0,125 mm.

4. Source de matière de revêtement selon l'une quelconque des revendications précédentes 1 à 3, **caractérisée en ce que** l'épaisseur de la cible (601, 701) s'élève de 6 mm à 18 mm et présente de préférence une épaisseur de 6 mm à 12 mm.

5. Source de matière de revêtement selon l'une quelconque des revendications précédentes 1 à 4, **caractérisée en ce qu'**en tant que mesures appropriées pour fixer la cible (601, 701) sur le support de source (605) il est prévu un système de fixation par baïonnette.

6. Source de matière de revêtement selon la revendication 4, **caractérisée en ce que** le périmètre (707) de la cible (701) agit conjointement avec le support de source sous la forme d'une fermeture par baïonnette, ce par quoi une compression élevée et homogène est réalisée.

7. Source de matière de revêtement selon l'une quelconque des revendications précédentes, **caractérisée en ce que** la cible (601, 701) est fabriquée par un procédé de métallurgie des poudres.

8. Méthode de revêtement de substrats, où, pour le dépôt d'une couche au moyen d'un procédé par pulvérisation cathodique, une source de matière de revêtement selon l'une quelconque des revendications précédentes 1 à 7 est employée.

9. Méthode selon la revendication 8, **caractérisé en ce que** la température d'une cible AlCr (70 : 30 % atomique) est au maximum de 193 °C, ou la température d'une cible AlTi (67 : 33 % atomique) est au maximum de 182 °C.

10. Méthode selon la revendication 9, **caractérisé en ce qu'**une puissance de pulvérisation cathodique jusqu'à 10 kW est employée sur la cible.

11. Méthode selon l'une quelconque des revendications précédentes 8 à 10, **caractérisé en ce qu'**une densité de puissance jusqu'à 100 W/cm² est employée sur une cible au chrome.

12. Méthode selon l'une quelconque des revendications précédentes 8 à 11, **caractérisé en ce que** la cible utilisée est une cible AlTi, AlCr, Al, Ti ou Cr.
